**Europäisches Patentamt**

**European Patent Office**

**Office européen des brevets**

(19)

(11) Publication number:

**0 018 739**
**B1**

(12)                    **EUROPEAN PATENT SPECIFICATION**

(45) Date of publication of patent specification: **02.11.89**

(51) Int. Cl.⁴: **H 03 M 7/00,** G 11 C 8/00

(21) Application number: **80301175.8**

(22) Date of filing: **11.04.80**

(54) A decoder circuit for a semiconductor memory device.

(30) Priority: **26.04.79 JP 51722/79**

(43) Date of publication of application:
**12.11.80 Bulletin 80/23**

(45) Publication of the grant of the patent:
**02.11.89 Bulletin 89/44**

(84) Designated Contracting States:
**DE GB NL**

(56) References cited:
**US-A-3 624 620**

**IBM TECHNICAL DISCLOSURE BULLETIN,
vol18, no.11, april 1976, New York, US,
FURMAN: "Address Buffer True Complement
Generator", pages 3597-3598**

(73) Proprietor: **FUJITSU LIMITED**
**1015, Kamikodanaka Nakahara-ku
Kawasaki-shi Kanagawa 211 (JP)**

(72) Inventor: **Isogai, Hideaki
153-2-716, Yanokuchi
Inagi-shi Tokyo 192-02 (JP)**

(74) Representative: **Rackham, Stephen Neil et al
GILL JENNINGS & EVERY 53-64 Chancery Lane
London WC2A 1HN (GB)**

## Description

The present invention relates to a decoder circuit for a semiconductor memory device.

A decoder circuit for a semiconductor memory device comprises address input terminals, address buffers, decoder lines, word drivers and word lines. The memory cells are connected to crossing points of the word lines and bit lines. In a typical decoder, constant current sources are provided in the address buffers, the decoder lines and the word drivers. When the number of the input terminals is N, the number of the address buffers is also N. The number of the decoder lines is 2N, and the number of word lines $2^N$. Accordingly, the number of constant current sources is equal to "$N+2N+2^N$". This means that the total current from all the current sources is large and the value of the total current becomes greater if the number of the input terminals N is increased.

Attempts have been made to produce a decoder circuit for a semiconductor device, which avoids this large number of constant current sources. Such a device is described in United States Patent Specification Number 3,914,620. In this device, no constant current sources are provided in the decoder lines and the word drivers, and so constant current sources are only provided in the address buffers. However, in this device, the raising of the potential of a decoder line to a HIGH level is effected by charging up the decoder line, which has a significant capacitance, through a resistor of the address buffer Because of the relatively high value of the time constant, a considerable length of time is required for the potential on the decoder line to build up when a signal is applied to an address input terminal, so that the speed of response of the decoder line to the input signal is reduced.

IBM Technical Disclosure Bulletin, Volume 18, No. 11, April 1976 at pages 3597/3598 discloses an address buffer inverter which comprises an inverter, output transistors, and a pair of switching transistors coupling output lines connected to the output transistors to a current source in a mode complementary to the operation of the output transistors.

The aim of the present invention is to overcome the problems of these earlier decoder circuits of existing semiconductor memory devices and provide a decoder with a short build-up time for the potential on the decoder lines whilst using only a limited number of constant current sources in the decoder.

According to this invention, a decoder circuit for a semiconductor memory device comprises a sequence of address signal input terminals, a number of address buffers, each of which includes a gate circuit for producing an address signal and an inverted address signal, a constant current source, connected to the gate circuit and transistors connected in an emitter follower configuration to form each output of the gate circuit, a number of pairs of decoder lines connected to the transistors with one of each pair of decoder lines being connected to the emitter follower connection transistor producing the address signal and the other of each pair of decoder lines being connected to the emitter follower connection transistor producing the inverted address signal, each pair of decoder lines being connected between its emitter follower connection transistor and an additional constant current source, each decoder line including a series connected switching transistor and resistor, the bases of the emitter follower configuration transistors being connected to the bases of the switching transistors by level changing circuits including level shifting diodes and other current sources, to obtain a quick start to the charging of the decoder lines, and to ensure that a major part of the current from each additional constant current source passes through only one decoder line of each pair at any instant, a sequence of word lines, and a number of word drivers each having a matrix of diodes or a multi-emitter transistor, a resistor circuit connected to a power source, and a transistor connected to one of the word lines, one end of each of the diodes or each emitter of the multi-emitter transistor being connected to one of the decoder lines and the other end of each diode or the collector of the multi-emitter transistor being connected to a junction of the resistor circuit and the base of said transistor being connected to one of the word lines.

Two examples of decoder circuits in accordance with this invention will now be described and contrasted with two earlier decoder circuits with reference to the accompanying drawings; in which:—

Figure 1A is a circuit diagram of a typical decoder circuit for a semiconductor memory device;

Figure 1B is a circuit diagram of three examples of constant current sources;

Figure 2 is a circuit diagram of a second decoder circuit for a semiconductor memory device;

Figure 3 is a circuit diagram of a first example of decoder circuit of a semiconductor memory device leading towards the present invention;

Figure 4 is a circuit diagram of a second example of decoder circuit for a semiconductor memory device leading towards the present invention; and

Figure 5 is a circuit diagram showing a modification of the first and second examples to provide a circuit in accordance with this invention.

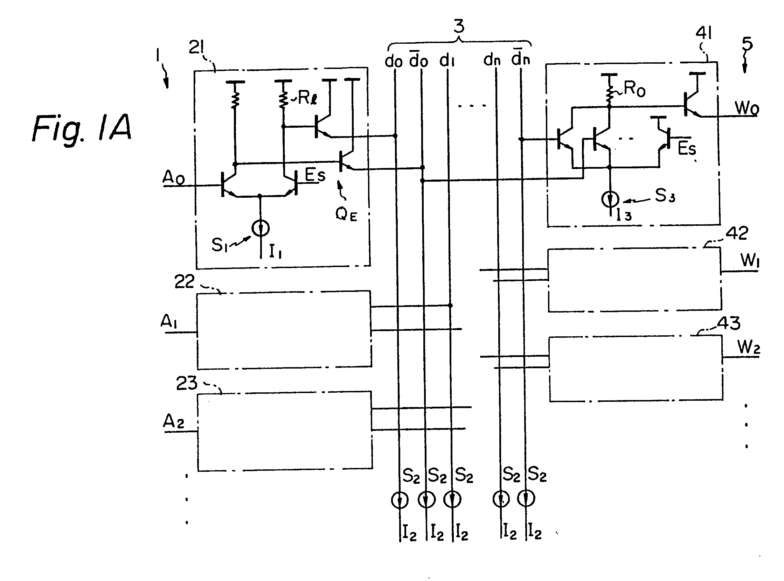

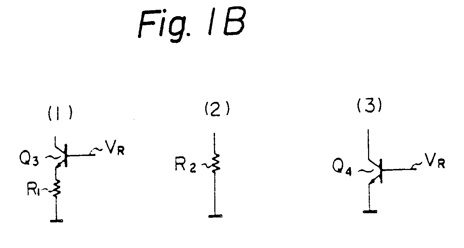

A typical conventional decoder circuit for a semiconductor memory device is shown in Figure 1A and comprises address input terminals 1 ($A_0$, $A_1$, $A_2$, ...), address buffers 21, 22, 23, ..., decoder lines 3 ($d_0$, $\bar{d}_0$, $d_1$, $\bar{d}_1$, ... $d_n$, $\bar{d}_n$), word drivers 41, 42, 43, ..., and word lines 5 ($W_0$, $W_1$, $W_2$ ...). Memory cells are connected to crossing points of the word lines and bit lines but the bit lines are not shown in Figure 1A. A transistor $Q_E$ connected in an emitter follower configuration is included in the address buffer. Constant current sources $S_1$, $S_2$, $S_3$ are provided in the address buffers, the decoder lines and the word drivers, respectively. Currents $I_1$, $I_2$ and $I_3$ pass through the constant current sources $S_1$, $S_2$ and $S_3$, respectively. Each of these constant current sources consists of, for example, one of the circuits (1), (2) and (3) illustrated in Figure 1B. The number of the input terminals $A_0$, $A_1$, $A_2$, ... is N. The number of the address buffers 21, 22, 23, ... is also N. The number of the decoder lines $d_0$, $\overline{d}_0$, $d_1$, $\overline{d}_1$ ... is 2N. The number of the word drivers 41, 42, 43, ... and accordingly the number of the word lines $W_0$, $W_1$, $W_2$, ... is $2^N$.

Thus, in this circuit the numbers of the constant current sources $S_1$, $S_2$ and $S_3$ are N, 2N and $2^N$ respectively, so that the total number of constant current sources is equal to $N+2N+2^N$. The total current I′ which passes through all the constant current sources is

$$I' = NI_1 + 2NI_2 + 2^N I_3,$$

if the constant current sources $S_1$, $S_2$ and $S_3$ consist of the circuits illustrated in Figure 1B which are operated in the normally-on manner. Accordingly, the value of the total current I′ becomes greater as the number of the input terminals N is increased.

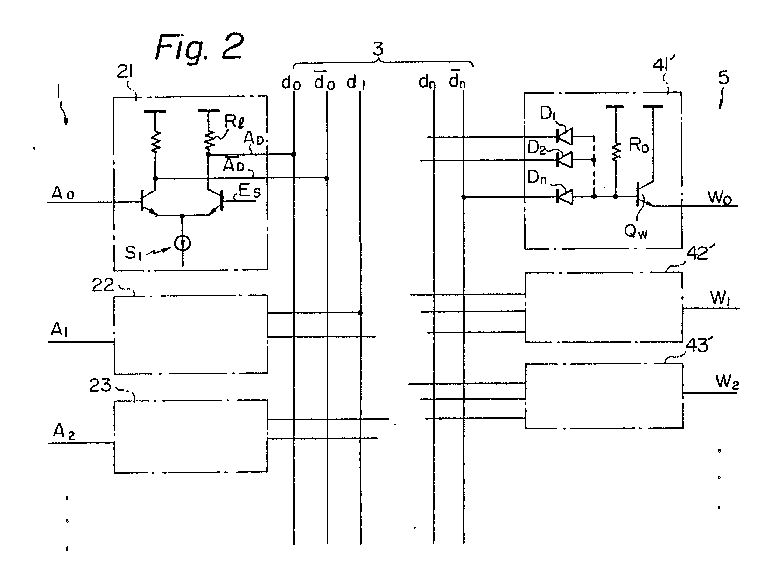

A prior art decoder circuit of a semiconductor circuit, which avoids the above described increase of the number of the constant current sources and value of the total current is shown in Figure 2 and this circuit is described in United States Patent Specification Number 3,914,620. This circuit comprises address input terminals $A_0$, $A_1$, $A_2$ ..., address buffers 21, 22, 23..., decoder lines 3 ($d_0$, $\overline{d}_0$, $d_1$, $\overline{d}_1$ ... $d_n$, $\overline{d}_n$), word drivers 41′, 42′, 43′, ... and word lines $W_0$, $W_1$, $W_2$, .... No constant current sources are provided in the decoder lines and the word drivers, so that constant current sources are provided only in the address buffers.

If the word line $W_0$ connected to the word driver 41′ is selected, every one of the diodes $D_1$, $D_2$, ... connected to the decoder lines is in an OFF state, thus transistor $Q_W$ is in an ON state, and accordingly the word line $W_0$ is at a HIGH level. On the contrary, if the word line $W_0$ connected to the word driver 41′ is not selected, at least one of the diodes $D_1$, $D_2$ ... connected to the decoder lines is in an ON state, thus the transistor $Q_W$ is in an OFF state, and accordingly, the word line $W_0$ is at a LOW level. A diode connected to a decoder line at a HIGH level is in an OFF state, while a diode connected to a decoder line at a LOW level is in an ON state. An input signal $A_0$ is compared with a reference signal $E_S$ in the address buffer 21. When the input signal $A_0$ is higher than the reference signal $E_S$, an output signal $\overline{A}_D$ of the address buffer is at a LOW level, so that the decoder line $\overline{d}_0$ is at a LOW level. On the contrary, when the input signal $A_0$ is lower than the reference signal $E_S$, and output signal $\overline{A}_D$ of the address buffer is at a HIGH level.

In this circuit, the number of constant current sources in only N. Assuming that the value of the current passing through the resistor $R_0$ of the word driver 41′ is equal to the value of the current $I_3$ passing through the constant current source $S_3$ of the word driver 41 and that the value of the current passing through a load resistance of the address buffer 21 in Figure 2 is negligible, the total current I″ which passes through the constant current sources is only $I'' = (2^N - 1)I_3$. This value of the total current I″ is considerably smaller than the total current I′ of the typical circuit shown in Figure 1A.

However, with this circuit, the raising of the potential of a decoder line to a HIGH level is effected by charging up the decoder line, which has a considerable capacitance $D_d$, through a resistor $R_l$ of the address buffer. Because of the value of the time constant $R_l C_d$, a significant length of time is required to build up the potential of the decoder line when a signal is applied to an address input terminal, so that the speed of response of the decoder line to the input signal is reduced.

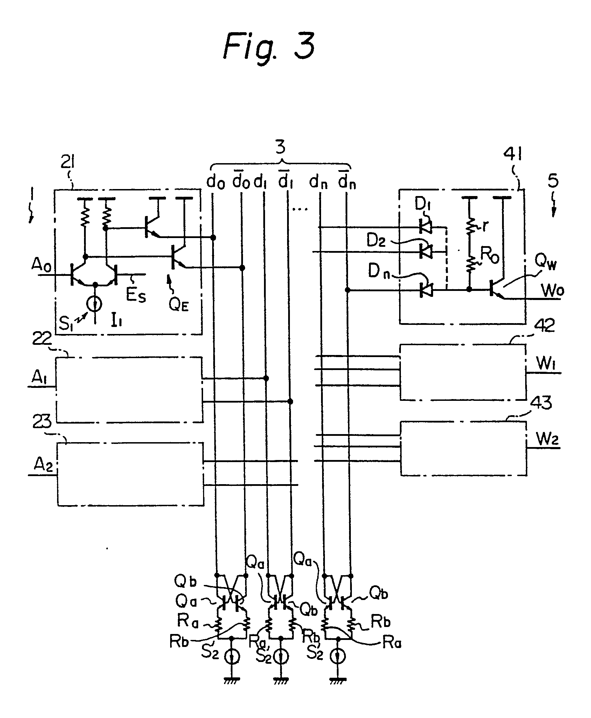

A decoder circuit for a semiconductor memory device leading towards the present invention is illustrated in Figure 3. This decoder circuit of Figure 3 comprises address input terminals 1 ($A_0$, $A_1$, $A_2$, ...), address buffers 21, 22, 23, ..., decoder lines 3 ($d_0$, $\overline{d}_0$, $d_1$, $\overline{d}_1$, ... $d_n$, $\overline{d}_n$), word drivers 41, 42, 43, ..., and word lines 5 ($W_0$, $W_1$, $W_2$, ...). The word drivers 41 include a plurality of diodes $D_1$, $D_2$, ... $D_n$ connected to the decoder lines. The address buffers 21 include transistors $Q_E$ connected in an emitter follower configuration to the decoder lines. A constant current source $S_2'$ is connected to each pair of decoder lines d and $\overline{d}$, through current switching transistors $Q_a$, $Q_b$ and resistors $R_a$, $R_b$.

In this circuit the raising of the potential of the decoder line to a HIGH level is effected directly by the power source through the emitter follower connection transistors $Q_E$. Accordingly, a quick building up of the potential of the decoder line is possible. The speed of response of the decoder line to the input signal in the circuit shown in Figure 3 is greater than that shown in Figure 2.

In the circuit shown in Figure 3, the number of the constant current sources is N+N, the total current I which passes the constant current sources is

$$``I = NI_1 + (2^N - 1)I_3",$$

assuming that the value of the current passing the resistor $R_0$ is equal to the value of the current $I_3$ in the circuit shown in Figure 1A.

Thus, in this circuit the operational characteristics are improved without providing too great a number of the constant current sources and without requiring too great a value of the total current. The structure of the word driver is also simpler than that shown in Figure 1A which in turn means that the price of the decoder circuit is reduced.

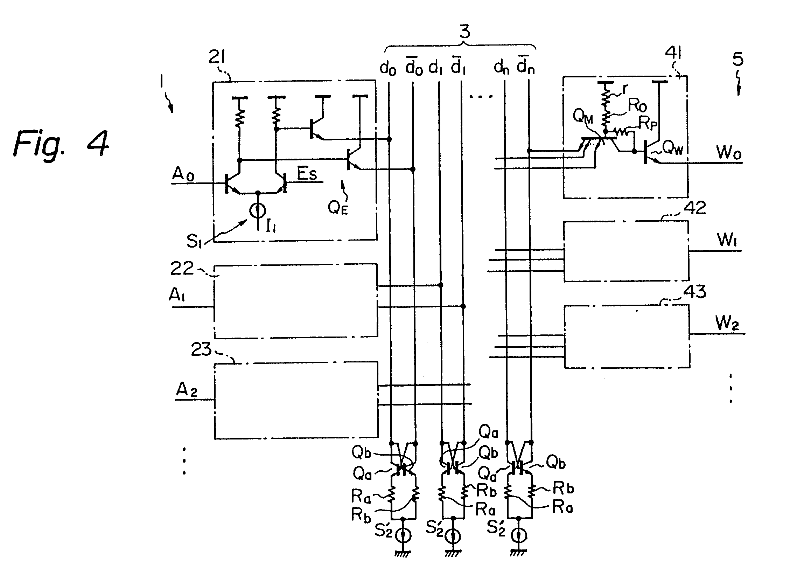

A second example of decoder circuit leading towards this invention is shown in Figure 4. In this circuit, a multi-emitter transistor $Q_M$ is used in the word drivers 41, instead of a plurality of diodes as used in the first example. In the circuit shown in Figure 4, the speed of building up the potential of the decoder line is reduced still further than that in the circuit shown in Figure 3, because the amplitude of the potential applied to the decoder line is reduced.

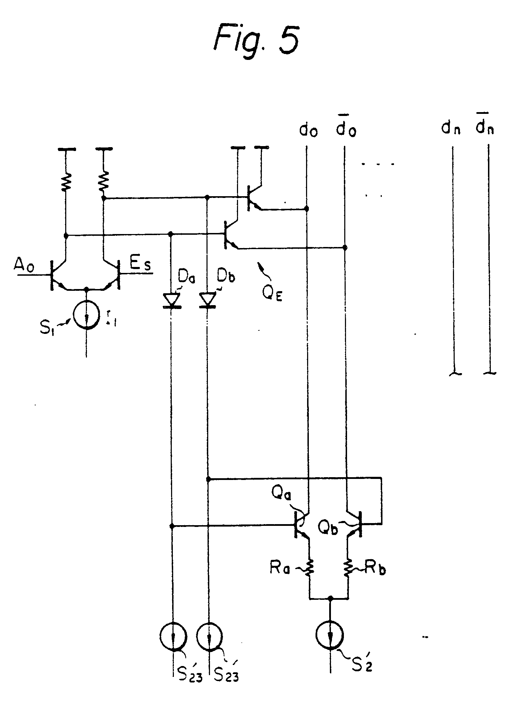

In accordance with this invention the decoder circuit as illustrated in Figure 3 or 4 is modified as shown in Figure 5. In this modification, the signals applied to the bases of the switching transistors $Q_a$ and $Q_b$ are supplied from the address buffers through level shifting diodes $D_a$ and $D_b$. With this modification it is possible to effect a quick start of the charging of the decoder line so that the speed of the operation of the decoder circuit is increased still further.

## Claim

A decoder circuit for a semiconductor memory device comprising a sequence of address signal input terminals ($A_0$, $A_1$, ... $A_n$), a number of address buffers (21, 22, ... 2m+1), each of which includes a gate circuit for producing an address signal and an inverted address signal, a constant current source ($S_1$), connected to the gate circuit and transistors ($Q_E$) connected in an emitter follower configuration to form each output of the gate circuit, a number of pairs ($d_0$, $\overline{d}_0$, $d_1$, $\overline{d}_1$, ... $d_n$, $\overline{d}_n$) of decoder lines (3) connected to the transistors ($Q_E$) with one of each pair ($d_0$, $d_1$, ... $d_n$) of decoder lines being connected to the emitter follower connection transistor ($Q_E$) producing the address signal and the other of each pair ($\overline{d}_0$, $\overline{d}_1$, ... $\overline{d}_n$) of decoder lines (3) being connected to the emitter follower connection transistor ($Q_E$) producing the inverted address signal, each pair ($d_0$, $\overline{d}_0$, $d_1$, $\overline{d}_1$; ... $d_n$, $\overline{d}_n$) of decoder lines (3) being connected between its emitter follower connection transistor ($Q_E$) and an additional constant current source ($S_2'$), each decoder line ($d_0$, $\overline{d}_0$, $d_1$, $\overline{d}_1$, ... $d_n$, $\overline{d}_n$) including a series connected switching transistor ($Q_a$, $Q_b$) and resistor ($R_a$, $R_b$), the bases of the emitter follower configuration transistors ($Q_E$) being connected to the bases of the switching transistors ($Q_a$, $Q_b$) by level changing circuits including level shifting diodes ($D_a$, $D_b$) and other current sources ($S_{23}'$), to obtain a quick start to the charging of the decoder lines ($d_0$, $\overline{d}_0$, $d_1$, $\overline{d}_1$, ... $d_n$, $\overline{d}_n$), and to ensure that a major part of the current from each additional constant current source ($S_2'$) passes through only one decoder line ($d_0$, $d_1$, ... $d_n$ or $\overline{d}_0$, $\overline{d}_1$, ... $\overline{d}_n$) of each pair at any instant, a sequence of word lines ($W_0$, $W_1$, ... $W_n$), and a number of word drivers (41, 42, ... 4n) each having a matrix of diodes ($D_1$, $D_2$, ... $D_n$) or a multi-emitter transistor ($Q_m$), a resistor circuit ($R_0$) connected to a power source, and a transistor ($Q_w$) connected to one of the word lines ($W_0$, $W_1$, ... $W_n$), one end of each of the diodes ($D_1$, $D_2$ ... $D_n$) or each emitter of the multi-emitter transistor ($Q_m$) being connected to one of the decoder lines ($d_0$, $\overline{d}_0$, $d_1$, $\overline{d}_1$, ... $d_n$, $\overline{d}_n$) and the other end of each

diode ($D_1$, $D_2$, ... $D_n$) or the collector of the multi-emitter transistor ($Q_m$) being connected to a junction of the resistor circuit and the base of said transistor ($Q_w$) being connected to one of the word lines ($W_0$, $W_1$, ... $W_n$).

## Patentanspruch

Decoderschaltung für eine Halbleiterspeicher-vorrichtung mit einer Folge von Adreßsignaleing-angsanschlüssen ($A_0$, $A_1$, ... $A_n$), einer Anzahl von Adreßpuffern (21, 22, ... 2n+1), von denen jeder eine Gateschaltung zur Erzeugung eines Adreßsignals und eines invertierten Adreßsignals enthält, einer Konstantstromquelle ($S_1$), die mit der Gate-schaltung verbunden ist, und Transistoren ($Q_E$), die in einer Emitterfolgerkonfiguration angeschlossen sind, um jeden Ausgang der Gateschaltung zu bilden, einer Anzahl von Paaren ($d_0$, $\overline{d}_0$, $d_1$, $\overline{d}_1$, ... $d_n$, $\overline{d}_n$) von Decoderleitungen (3), die mit den Transistoren ($Q_E$) verbunden sind, wobei eine von jedem Paar ($d_0$, $d_1$, ... $d_n$) von Decoderleitun-gen, die mit dem Emitterfolgerverbindungstransi-stor ($Q_E$) verbunden sind, das Adreßsignal erzeugt, und die andere von jedem Paar ($\overline{d}_0$, $\overline{d}_1$, ... $\overline{d}_n$) von Decodierleitungen (3), die mit dem Emitterfolgerverbindungstransistor ($Q_E$) verbunden ist, das invertierte Adreßsignal erzeugt, jedes Paar ($d_0$, $\overline{d}_0$, $d_1$, $\overline{d}_1$; ... $d_n$, $\overline{d}_n$) von Decoderleitun-gen (3) zwischen seinem Emitterfolgerverbin-dungstransistor ($Q_E$) und einer zusätzlichen Kon-stantstromquelle ($S_2'$) verbunden ist, jede Deco-derleitung ($d_0$, $\overline{d}_0$, $d_1$, $\overline{d}_1$ ... $d_n$, $\overline{d}_n$) eine Reihen-schaltung aus einem Schalttransistor ($Q_a$, $Q_b$) und einen Widerstand ($R_a$, $R_b$) umfaßt, wobei die Basen der Emitterfolgerkonfigurationstransistoren ($Q_E$) mit den Basen der Schalttransistoren ($Q_a$, $Q_b$) durch Pegeländerungsschaltungen verbun-den sind, die Pegelverschiebedioden ($D_a$, $D_b$) und andere Stromquellen ($S_{23}'$) enthalten, um einen schnellen Start für das Aufladen der Decoderlei-tungen ($d_0$, $\overline{d}_0$, $d_1$, $\overline{d}_1$, ... $d_n$, $\overline{d}_n$) zu erhalten, und um zu gewährleisten, daß ein größerer Teil des Stromes von jeder zusätzlichen Konstantstrom-quelle ($S_2'$) durch nur eine Decoderleitung ($d_0$, $d_1$, ... $d_n$ oder $\overline{d}_0$, $\overline{d}_1$, ... $\overline{d}_n$) von jedem Paar in jedem Augenblick fließt, einer Folge von Wortleitungen ($W_0$, $W_1$, ... $W_n$) und einer Anzahl von Worttreibern (41, 42, ... 4n), die jeweils eine Matrix von Dioden ($D_1$, $D_2$, ... $D_n$) oder einen Multiemittertran-sistor ($Q_m$), eine Widerstandsschaltung ($R_0$), die mit einer Energiequelle verbunden ist, und einen Transistor ($Q_w$), der mit einer der Wortleitungen ($W_0$, $W_1$, ... $W_n$) verbunden ist, haben, wobei ein Ende von jeder der Dioden ($D_1$, $D_2$, ... $D_n$) oder jeder Emitter von dem Multiemittertransistor ($Q_m$) mit einer der Decoderleitungen ($d_0$, $\overline{d}_0$, $d_1$, $\overline{d}_1$, ... $d_n$, $\overline{d}_n$) verbunden ist, und das andere Ende von jeder Diode ($D_1$, $D_2$, ... $D_n$) oder des Kollektors des Multiemittertransistors ($Q_m$) mit dem Verbin-dungspunkt der Widerstandsschaltung verbun-den ist, und die Basis des genannten Transistors ($Q_w$) mit einer der Wortleitungen ($W_0$, $W_1$, ... $W_n$) verbunden ist.

## Revendication

Circuit décodeur pour dispositif de mémorisation semiconducteur comprenant une série de bornes d'entrée de signal d'adress ($A_0$, $A_1$, ... $A_n$), un certain nombre de tampons d'adresse (21, 22, ... 2n+1), qui comportent chacun un circuit de porte servant à produire un signal d'adresse et un signal d'adresse inversé, une source de courant constant ($S_1$) connectée au circuit de porte et des transistors ($Q_E$) connectés en configuration d'émetteur suiveur de manière à former chaque sortie du circuit de porte, un certain nombre de paires ($d_0$, $\overline{d}_0$, $d_1$, $\overline{d}_1$, ... $d_n$, $\overline{d}_n$) de lignes (3) de décodeur connectées aux transistors ($Q_E$), où une ligne de chaque paire ($d_0$, $d_1$, ... $d_n$) de lignes de décodeur est connectée au transistor à connexion en émetteur suiveur ($Q_E$) qui produit le signal d'adresse et l'autre ligne de chaque paire ($\overline{d}_0$, $\overline{d}_1$, ... $\overline{d}_n$) de lignes (3) de décodeur est connectée au transistor à connexion en émetteur suiveur ($Q_E$) qui produit le signal d'adresse inversé, chaque paire ($d_0$, $\overline{d}_0$, $d_1$, $\overline{d}_1$, ... $d_n$, $\overline{d}_n$) de lignes (3) de décodeur étant connectée entre son transistor ($Q_E$) à connexion en émetteur suiveur et une source de courant constant supplémentaire ($S_2'$), chaque ligne de décodeur ($d_0$, $\overline{d}_0$, $d_1$, $\overline{d}_1$, ... $d_n$, $\overline{d}_n$) comportant un transistor de commutation ($Q_a$, $Q_b$) et une résistance ($R_a$, $R_b$) connectés en série, les bases des transistors en configuration d'émetteur suiveur ($Q_E$) étant connectées aux bases des transistors de commutation ($Q_a$, $Q_b$) par des circuits de changement de niveau comportant des diodes de changement de niveau ($D_a$, $D_b$) et d'autres sources de courant ($S_{23}'$), afin d'obtenir un démarrage rapide du chargement des lignes de décodeur ($d_0$, $\overline{d}_0$, $d_1$, $\overline{d}_1$, ... $d_n$, $\overline{d}_n$) et d'assurer qu'une majeure partie du courant venant de chaque source de courant constant supplémentaire ($S_2'$) passe par une seule ligne de décodeur ($d_0$, $d_1$, ... $d_n$ ou bien $\overline{d}_0$, $\overline{d}_1$, ... $\overline{d}_n$) de chaque paire à tout instant, une série de lignes de mot ($W_0$, $W_1$, ... $W_n$), et un certain nombre d'éléments de commande de mot (41, 42, ... 4n) ayant chacun une matrice de diodes ($D_1$, $D_2$, ... $D_n$) ou un transistor multiémetteur ($Q_m$), un circuit de résistance ($R_0$) connecté à une source d'alimentation électrique et un transistor ($Q_w$) connecté à l'une des lignes de mot ($W_0$, $W_1$, ... $W_n$), une extrémité de chacune des diodes ($D_1$, $D_2$, ... $D_n$) ou chaque émetteur du transistor multiémetteur ($Q_m$) étant connecté à l'une des lignes de décodeur ($d_0$, $\overline{d}_0$, $d_1$, $\overline{d}_1$, ... $d_n$, $\overline{d}_n$) et l'autre extrémité de chaque diode ($D_1$, $D_2$, ... $D_n$) ou le collecteur du transistor multi-émetteur ($Q_m$) étant connecté à un point de jonction du circuit de résistance et de la base dudit transistor ($Q_w$) étant connectée à l'une des lignes de mot ($W_0$, $W_1$, ... $W_n$).

Fig. IA

EP 0 018 739 B1

# Fig. IB

(1)

(2)

(3)

Fig. 2

EP 0 018 739 B1

EP 0 018 739 B1

Fig. 3

4

Fig. 4

# Fig. 5